# EUROPEAN PATENT SPECIFICATION

(11) **EP 2 565 919 B1**
(45) Date of publication and mention of the grant of the patent: **22.04.2020**
(21) Application number: 12182194.6
(22) Date of filing: 29.08.2012
(51) Int. Cl.: H01L 23/40, H01L 23/467

(54) **Heat sink**
Kühlkörper
Dissipateur de chaleur

(30) Priority: 02.09.2011 TW 100131835
(43) Date of publication of application: 06.03.2013
(73) Proprietor: Giga-Byte Technology Co., Ltd., New Taipei City 231 (TW)
(72) Inventor: Tai, Chuan Mao, New Taipei City 231 Taiwan (TW)
(74) Representative: Plasseraud IP

(56) References cited:
- US-A- 4 715 438
- US-A- 4 833 766
- US-A1- 2007 181 287
- US-A1- 2008 041 562
- US-A1- 2010 108 292
- US-B1- 6 179 046
- US-B1- 6 899 164
- US-B2- 7 573 714

## Description

### BACKGROUND OF THE INVENTION

### 1. Field of the Invention

The present invention relates to a heat sink, especially to a heat sink with a guiding face.

### 2. Description of Related Art

Most of the electronic devices such as central processing units (CPU), graphic processing units (GPU) and memory devices generate heat during data processing. If an electronic device in operation can't effectively dissipate the heat, the accumulated heat will adversely affect the electronic device itself and the operation speed. Moreover, when the temperature of the electronic device increases to a certain level, the operation thereof becomes unstable, or even the electronic device breaks down. Therefore, for an electronic device usually producing a lot of heat, the heat- dissipation efficiency thereof is particularly an important issue.

A heat dissipation module is generally used as a cooling means for removing the accumulated heat of an electronic device. The heat dissipation module includes a heat sink and a fan in cooperation therewith. The heat sink includes a heat dissipation base and a plurality of heat dissipation fins disposed on the heat dissipation base at intervals. Since the surface of the electronic device is designed to be in contact with the heat dissipation base, the heat is transferred from the electronic device to the heat dissipation fins by means of the heat dissipation base. During this process, the fan generates an airflow along the direction perpendicular to the heat dissipation base and the airflow is circulated between the plurality of heat dissipation fins and will touch the surface of the heat dissipation base, thereby removing the heat from the heat dissipation base and the heat dissipation fins. However, in such configuration, the airflow will first bump into the heat dissipation base along the direction perpendicular thereto and then reflect as a counter airflow having a reverse moving direction. This results in a turbulent flow between the heat dissipation fins, increased air resistance, and decreased heat dissipation efficiency.
Other examples and embodiments of the prior art may be found in US 6 899 164.

Hence, there is a need to solve the unsatisfactory heat dissipation effect caused by the counter airflow having the reverse moving direction counteracting the original airflow generated by the fan as mentioned above.

### SUMMARY OF THE INVENTION

In view of the above, the present invention provides a heat sink that can solve the problem of insufficient heat dissipation of the heat sink mainly caused by the counter airflow.

In one embodiment of the present invention, a heat sink in cooperation with a fan capable of generating an airflow along a first axial direction is disclosed. The heat sink comprises a connecting piece and a plurality of air guide fins disposed on the connecting piece at intervals. Each of the air guide fins has a guiding face that confronts the airflow in the first axial direction and directs the airflow to a second axial direction, the fan is disposed on the connecting piece and the connecting piece is between the fan and the plurality of air guide fins.

The advantage of the present invention is that through the guiding faces of the air guide fins directing the airflow from the fan, the direction of the airflow can be directed from the first axial direction to the second axial direction. In this way, the airflow is prevented from bumping into the connecting piece of the heat sink or the electronic device located under the heat sink, and a sufficient wind pressure can be retained. Meanwhile, the airflow along the second axial direction further helps to push the airflow flowing between the plurality of the air guide fins and circulate the air around the heat sink, so the airflow generated by the fan can be fully utilized to achieve a good heat dissipation effect.

These and other objectives of the present invention will no doubt become obvious to those of ordinary skill in the art after reading the following detailed description of the preferred embodiments that are illustrated in the various figures and drawings.

### BRIEF DESCRIPTION OF THE DRAWINGS

Fig. 1 is a three-dimensional illustration for a first embodiment of the present invention.
Fig. 2 is a schematic illustration for the flow direction of the airflow in the first embodiment of the present invention.
Fig. 3 is a three-dimensional illustration for another arrangement of the heat sink of the present invention.
Fig. 4 is a three-dimensional illustration for a second embodiment of the present invention.
Fig. 5 is a schematic illustration for the flow direction of the airflow in the second embodiment of the present invention.
Fig. 6 is a three-dimensional illustration for several heat dissipation fins disposed on the two opposite sides of each air guide fin of the second embodiment of the present invention.
Fig. 7 is an exploded illustration for a third embodiment of the present invention.
Fig. 8 is a schematic illustration for the flow direction of the airflow in the third embodiment of the present invention.
Fig. 9 is a top view of a fourth embodiment of the present invention.
Fig. 10 is a partially cross-sectional view of the fourth embodiment of the present invention.
Fig. 11 is an exploded illustration of a fifth embodiment of the present invention.
Fig. 12 is a schematic illustration for the flow direction of the airflow in the fifth embodiment of the present invention.

### DETAILED DESCRIPTION OF THE PREFERRED EMBODIMENTS

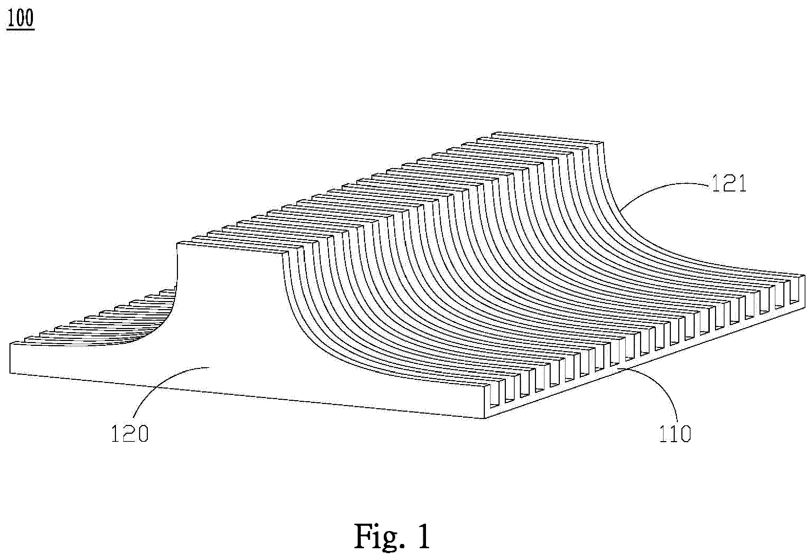

As shown in Fig. 1, the heat sink 100 of the first embodiment of the present invention includes a connecting piece 110 and a plurality of air guide fins 120. The connecting piece 110 and the plurality of air guide fins can be, but not limited to the metal sheets or metal plates made of aluminum or copper for example. The plurality of air guide fins 120 are arranged to "stand" (erect) on the connecting piece 110 at intervals and may be formed integrally by extending from the connecting piece 110. Alternatively, the air guide fins 120 may be formed separately on the connecting piece 110 at intervals through soldering, welding or the like. Each air guide fin 120 is provided with two guiding faces 121 at the side away from the connecting piece 110. Besides, the two guiding faces 121 are located at the two opposite sides of the air guide fin 120 obliquely with respect to the connecting piece 110. For example, the guiding face 121 may be a curved surface or an inclined plane.

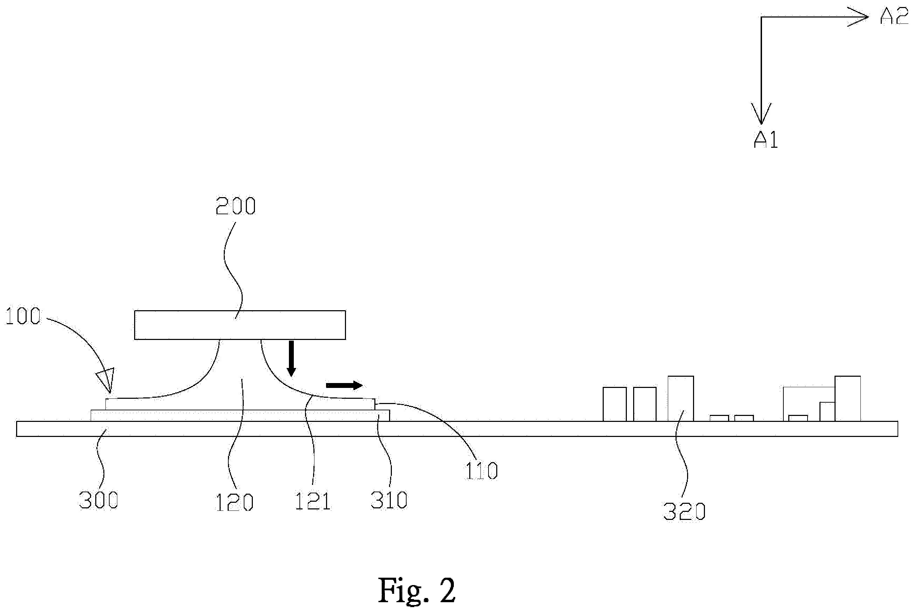

Referring to Figs. 1-2, the heat sink 100 of the first embodiment of the present invention works with a fan 200. The heat sink 100 is located between the fan 200 and a circuit board 300, and connected with or attached to a main electronic component 310 such as central processing units (CPU) or graphic processing units (GPU) on the circuit board 300. Therefore, the heat produced by the main electronic component 310 will be conveyed to each of the air guide fins 120 through the connecting piece 110 of the heat sink 100. Meanwhile, an airflow is generated by the fan 200 to blow towards the heat sink 100 along a first axial direction A1 parallel to the axle of the fan 200, thereby disturbing the airflow and facilitating the air circulation between the plurality of air guide fins 120. As a result, heat exchange occurs between the air around the air guide fins 120 and the air, in the surrounding, so the heat produced by the main electronic component 310 on the circuit board 300 can be dispersed.

Besides, after contacting with and bumping into the guiding face 121 of the air guide fins 120 along the first axial direction A1, the airflow is directed by the guiding face 121 to move from the first axial direction A1 to a second axial direction A2 which is perpendicular or inclined to the first axial direction A1. For instance, the airflow may be made to flow along the direction parallel to the surface of the circuit board 300, so that heat generated by other electronic components 320 such as capacitors and resistors on the surface of the circuit board 300 can be dispersed at the same time. Although when the airflow flows along the first axial direction A1, part of the airflow bumps into the surface of the connecting piece 110 exposed amid the plurality of air guide fins 120 and then reflects, the reflected airflow will be affected by the airflow flowing along the second axial direction A2. Therefore, the turbulent flow caused by the onward and backward airflows may be reduced. In a preferred embodiment, the first axial direction A1 is substantially perpendicular to the second axial direction A2. In this way, when the airflow flows in the first axial direction A1, the wind resistance caused by the mutual interference between the airflow flowing towards the connecting piece 110 and flowing towards the fan 200 is reduced, so the heat dissipation efficiency of the heat sink 100 is improved.

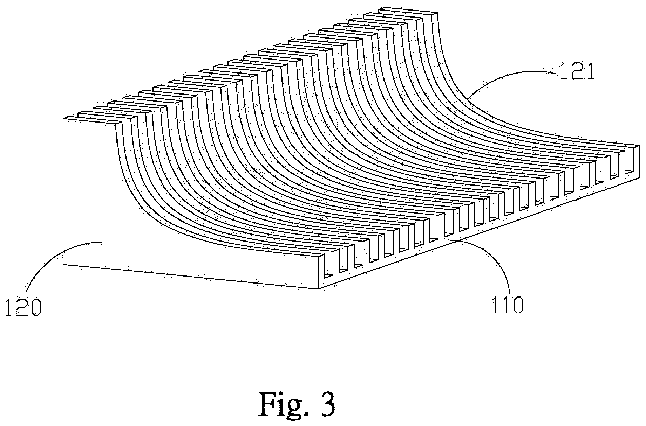

Furthermore, although two guiding faces 121 are used for exemplary illustration for each of the air guide fins 120 in the first embodiment of the present invention, while in another embodiment of this invention, a single guiding face 121 is disposed for each of the air guide fins 120 at the same side as shown in Fig. 3 to direct the flow direction of the airflow, thereby avoiding the turbulent flow on the surface of the connecting piece 110 or the circuit board 300. It is to be noted that the number of the guiding faces on the air guide fins can be determined as the case may be and thus is not limitative in the present invention. For example, distribution or range of electronic components on the circuit board may be considered when determining the number of the guiding faces for each air guide fin.

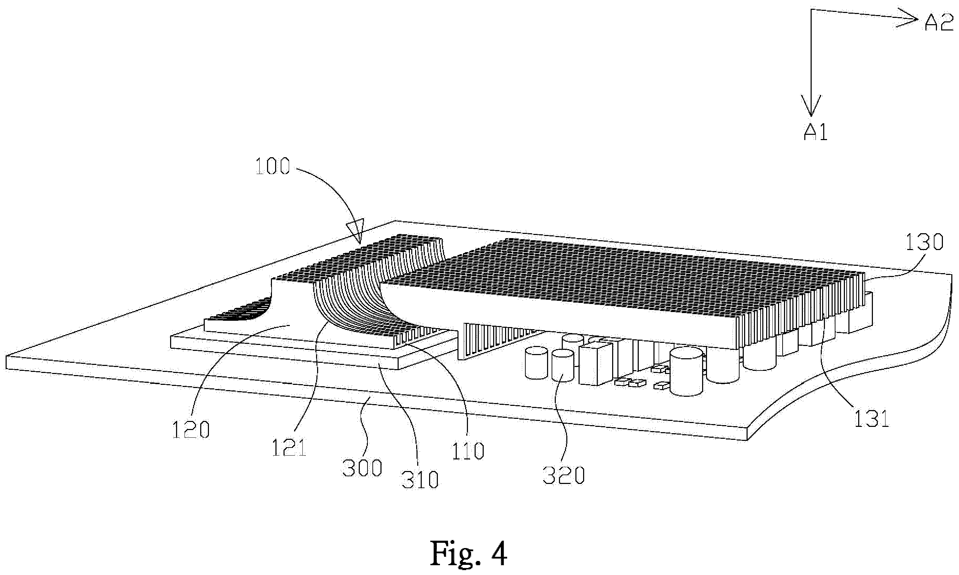

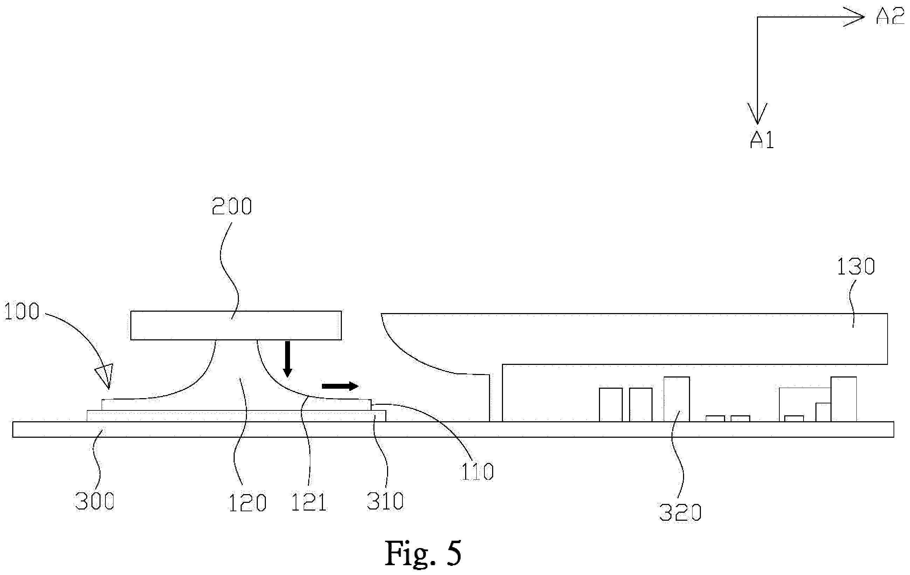

As shown in Figs. 4 and 5, the heat sink 100 of a second embodiment of the present invention includes a connecting piece 110, a plurality of air guide fins 120 and a plurality of heat dissipation fins 130 which may be (but not limited to) metal sheets or metal plates composed of for example aluminum or copper. In this embodiment, the air guide fins 120 are made of copper, while the heat dissipation fins 130 are made of aluminum. However, it should be appreciated that the present invention is not limited thereto. The plurality of air guide fins 120 are spaced apart sequentially and erect on the connecting piece 110. Also, the air guide fins 120 may be formed integrally or separately with the connecting piece 110. Moreover, each air guide fins 120 has two guiding faces 121 at the sides away from the connecting piece 110. The two guiding faces 121 are oblique with respect to the connecting piece 110 and located at two opposite sides of the air guide fin 120. As an exemplary aspect, the guiding face 121 may be in the form of a curved surface or an inclined plane.

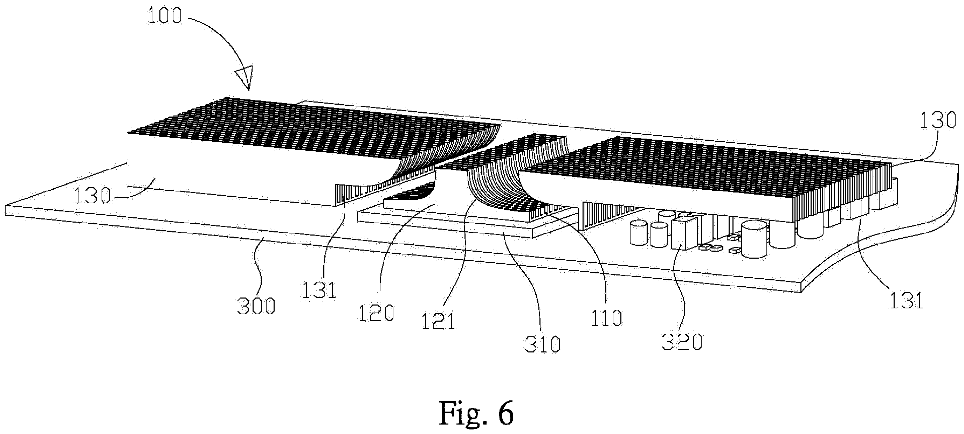

In practice, the heat sink 100 is disposed on a circuit board 300 together with a fan 200. The connecting piece 110 of the heat sink 100 attached to a main electronic component 310 on the circuit board 300 and the plurality of air guide fins 120 are located between the circuit board 300 and the fan 200. A plurality of heat dissipation fins 130 are arranged on the circuit board 300 at intervals to form an airflow channel 131 between two adjacent heat dissipation fins 130. The plurality of the heat dissipation fins 130 can be placed on one side or two opposite sides of the plurality of air guide fins 120 respectively (as shown in Fig. 6); however, this is not a limitation to the present invention. Moreover, the airflow channels 131 of the air guide fins 130 align with the guiding faces 121 of the air guide fins 120.

Hence, when the fan 200 produces an airflow towards the air guide fins 120 along a first axial direction A1 parallel to the axle of the fan 200, air between the plurality of air guide fins 120 is subject to disturbance and heat exchange of the air with the surrounding occurs. The heat from the main electronic component 310 on the circuit board 300 is dispersed to the outside and the temperature of the main electronic component 310 is decreased. In more detail, the airflow is directed by the guiding face 121 of the air guide fin 120 from the first axial direction A1 to a second axial direction A2 parallel to the surface of the circuit board 300 and further into the airflow channel 131 of the heat dissipation fin 130. Afterwards, and the airflow flows over the surface of the circuit board 300 along the airflow channel 131 that functions to collect and guide the airflow.

Therefore, in the heat sink 100 of the second embodiment of the present invention, on one hand, the wind resistance caused by the airflow above the surface of the connecting piece 110 of the heat sink 100 or the surface of the circuit board 300 can be directed from the first axial direction A1 to the second axial direction A2 by the guiding faces 121 of the air guide fins 120; on the other hand, the heat exchange effect of the airflow moving above the surface of the circuit board 300 is improved. In addition, the airflow will blow over other electronic components 320 on the circuit board 300 intensively, which increases the range of the heat dissipation for the circuit board 300.

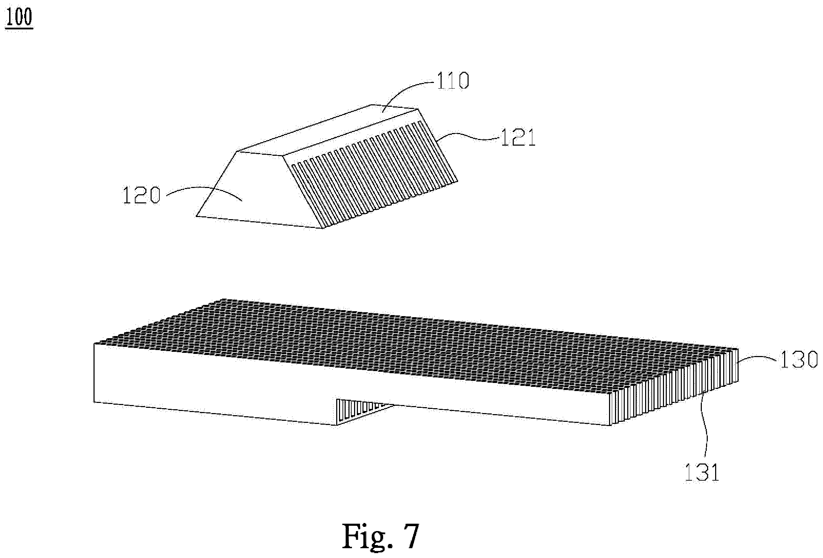

As shown in Fig. 7, the heat sink 100 of a third embodiment of the present invention includes a connecting piece 110, a plurality of air guide fins 120 and a plurality of heat dissipation fins 130. The connecting piece 110 and the air guide fins 120 can be, but not limited to plastic sheets or plastic plates, and the heat dissipation fins 130 can be, but not limited to the metal sheets or metal plates of aluminum or copper for example. The air guide fins 120 are arranged at one side surface of the connecting piece 110 at intervals and formed on the surface of the connecting piece 110 integrally through injection molding as a comb. Besides, the air guide fin 120 has a shorter length at the end connected with the connecting piece 110 than at the end away from the connecting piece 110; that is, the air guide fin 120 has a profile of trapezoid. In the third embodiment, the guiding face 121 is formed as an inclined plane (a slope) at the opposite sides of each of the air guide fins 120.

The heat dissipation fins 130 are "sandwiched" between the plurality of air guide fins 120 respectively and similarly arranged on the surface of the connecting piece 110. More specifically, the plurality of heat dissipation fins 130 are located between the plurality of the air guide fins 120 along a first axial direction A1 from the end of the air guide fins 120 away from the connecting piece 110 to the end connected with the connecting piece 110. Moreover, the two opposite ends of the plurality of heat dissipation fins 130 respectively extend along a second axial direction A2 perpendicular to the first axial direction A1 to form a narrow gap like a corridor between the heat dissipation fins 130 acting as an airflow channel 131 for guiding the airflow.

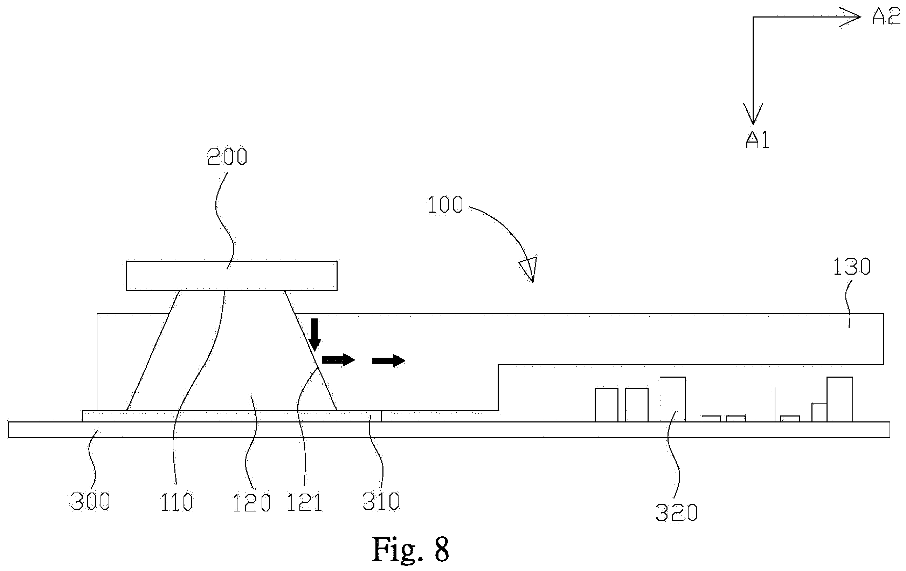

Referring to Figs. 7 and 8, during the heat dissipation process, the heat sink 100 is placed between the fan 200 and the circuit board 300 and contacts with a main electronic component 310 (e.g. a graphic processing unit) of the circuit board 300 through a plurality of heat dissipation fins 130. Hence, when the fan 200 produces an airflow blowing toward the circuit board 300 along a first axial direction A1, the airflow will soon confront and bump into the guiding faces 121 of the air guide fins 120 along the first axial direction A1, and then flow from the first axial direction A1 to a second axial direction A2 under the guidance of the guiding faces 121. After that, the airflow will mainly flow in the airflow channels 131 between the heat dissipation fins 130 along the second axial direction A2 in a stable way. As a result, not only the heat generated by the main electronic component 310 on the circuit board 300 is removed more efficiently, but also the effective heat dissipation area on the circuit board 300 is increased covering the other electronic components 320. In addition, the possibility of forming a turbulent flow on the surface of the circuit board 300 is greatly reduced.

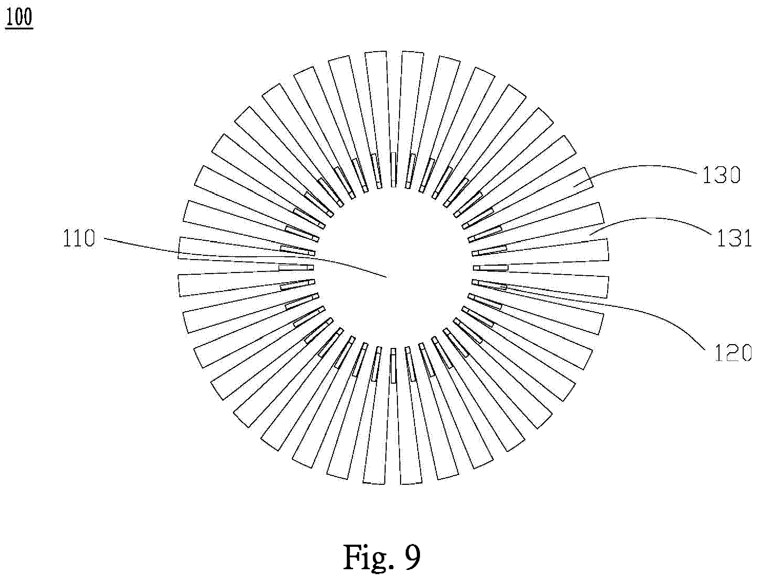

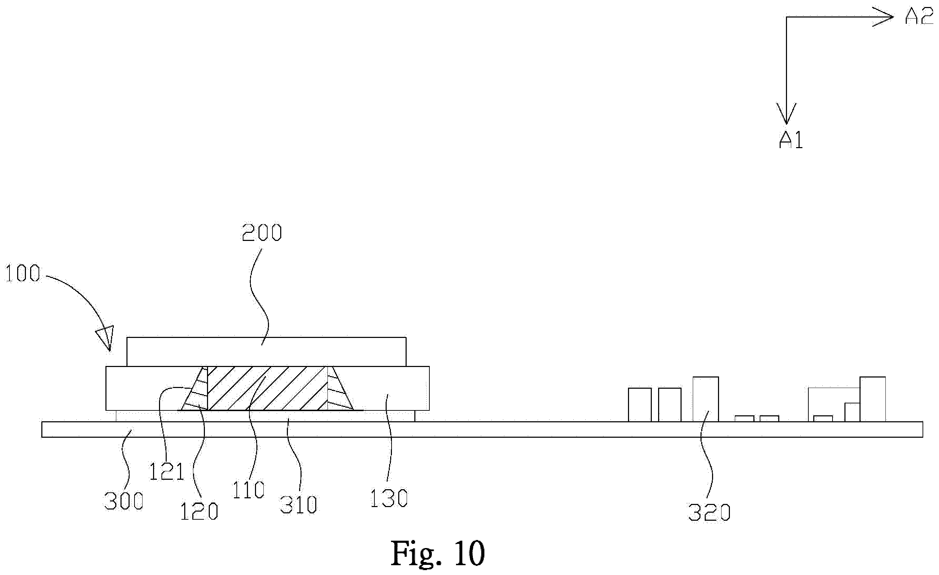

Referring to Figs. 9 and 10, the heat sink 100 of a fourth embodiment of the present invention includes a connecting piece 110, a plurality of air guide fins 120 and a plurality of heat dissipation fins 130, in which the connecting piece 110 is in the form of a cylinder, and the heat dissipation fins 130 are arranged annularly on the connecting piece 110 at intervals so that an airflow channel 131 is formed between two adjacent heat dissipation fins 130. Particularly, the heat dissipation fins 130 may be formed integrally with the connecting piece 110 or joined to the connecting piece 110 by soldering or welding for example, while this is not a limitation to this invention. Furthermore, the heat dissipation fins 130 may be, but not limited to the metal sheets or metal plates of aluminum or copper, and the air guide fins 120 may be, but not limited to metal sheets or metal plates of aluminum or copper or plastic plates for example.

Each of the plurality of air guide fins 120 is disposed detachably in the airflow channel 131 between two adjacent heat dissipation fins 130 or connected to the surface of the connecting piece 110 in a detachable way, wherein the area of the air guide fin 120 is smaller than the area of the heat dissipation fin 130. Besides, for each air guide fin 120, a guiding face 121 is obliquely formed at the side of opposite to the connecting piece 110. The guiding face 121 may have a profile of triangle or trapezoid with an inclined plane thereon.

As shown in Figs. 9 and 10, the heat sink 100 of the fourth embodiment of the present invention performs heat dissipation of a circuit board 300 in cooperation with a fan 200 and is located between the fan 200 and the circuit board 300. The heat sink 100 contacts with the main electronic component 310 (such as a graphic processing unit) of the circuit board 300 through a side of the connecting piece 110 that adjoins the heat dissipation fins 130, so that the heat generated by the main electronic component 310 is transmitted to the heat dissipation fins 130 through the connecting piece 110. Besides, an airflow generated by the fan 200 flows towards the heat sink 100 and the circuit board 300 in a first axial direction A1 parallel to the axle of the fan 200 and thus disturbs the air in the airflow channels 131 between the heat dissipation fins 130. Heat exchange of the airflow with the surrounding air occurs accordingly. Since the heat from the main electronic component 310 on the circuit board 300 can be dissipated to the outside in the above way, the temperature of the main electronic component 310 can be decreased and the performance thereof can be improved.

The airflow generated by the fan 200 not only disturbs the air in the airflow channels 131 but also confronts and bumps into the air guide fins 120 in the airflow channels 131 along the first axial direction A1. Each of the air guide fins 120 is provided with a guiding face 121 capable of directing the airflow from the first axial direction A1 (e.g. the direction perpendicular to the surface of the circuit board 300) to a second axial direction A2 (e.g. the direction parallel to the surface of the circuit board 300), Then the airflow is further guided by the airflow channels 131 to flow outside the heat sink 100. However, part of the airflow will reflect when confronting the circuit board 300 or the main electronic component 310. The reflected airflow will flow in the second axial direction A2 under the influence of the airflow flowing along the second axial direction A2. Hence, occurrence of the turbulent flow in the airflow channels 131 can be reduced. In addition, with the heat dissipation fins 130 arranged on the connecting piece 110 in an annular or radial way, the airflow may flow away from the main electronic component 310 by the guidance of the guiding faces 121 of the air guide fins 120 and spread over the surface of the circuit board 300 radially. This helps to expand the reachable range for the airflow generated by the fan 200.

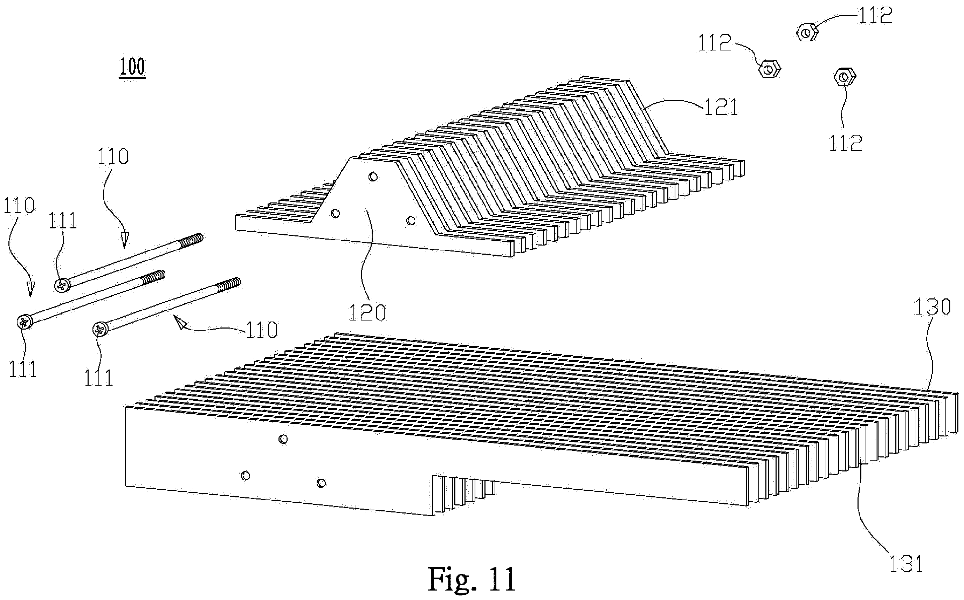

As shown in Fig. 11, the heat sink 100 of a fifth embodiment of the present invention includes at least one connecting piece 110, a plurality of air guide fins 120 and a plurality of heat dissipation fins 130. The connecting piece 110 thereof can be, but not limited to a nail, a screw or combination of a bolt and a nut. In the embodiment, the combination of a bolt 111 and a nut 112 is exemplified as the connecting piece 110, but this is not a limitation to the invention. The air guide fins 120 and the heat dissipation fins 130 can be, but not limited to metal sheets or metal plates of aluminum or copper for example. In this embodiment, the air guide fins 120 are made of copper while the heat dissipation fins 130 are made of aluminum. Besides, the heat dissipation fin 130 has a longer length than the air guide fin 120, and each of the air guide fins 120 has two opposed sides with different lengths. A guiding face 121 is provided to each air guide fin 120 by connecting the two opposed sides of the air guide fins 120 such that an inclined plane or a curved surface is formed thereon. In other words, the air guide fin 120 has a profile of trapezoid.

In assembly of the heat sink 100, the connecting piece 110 provided with a screw 111 on one end is used to pass through the air guide fins 120 near the side with a shorter length, and a nut 112 is used at the other end of the connecting piece 110 to fasten the air guide fins 120, as indicated in Fig. 11. Also, the air guide fins 120 are serially connected on the connecting piece 110 at intervals. Then, each of the heat dissipation fins 130 is placed between two adjacent air guide fins 120 so that the plurality of air guide fins 120 and the plurality of heat dissipation fins 130 are arranged interlacedly. Next, the nut 112 is further turned to tighten the plurality of air guide fins 120 and the plurality of heat dissipation fins 130. At this time, the air guide fins 120 and the heat dissipation fins 130 stay very close to each other due to the pressing provided by the screw 111 and the nut 112 from opposed directions, indicating that each of the heat dissipation fins 130 is "sandwiched" between two adjacent air guide fins 120.

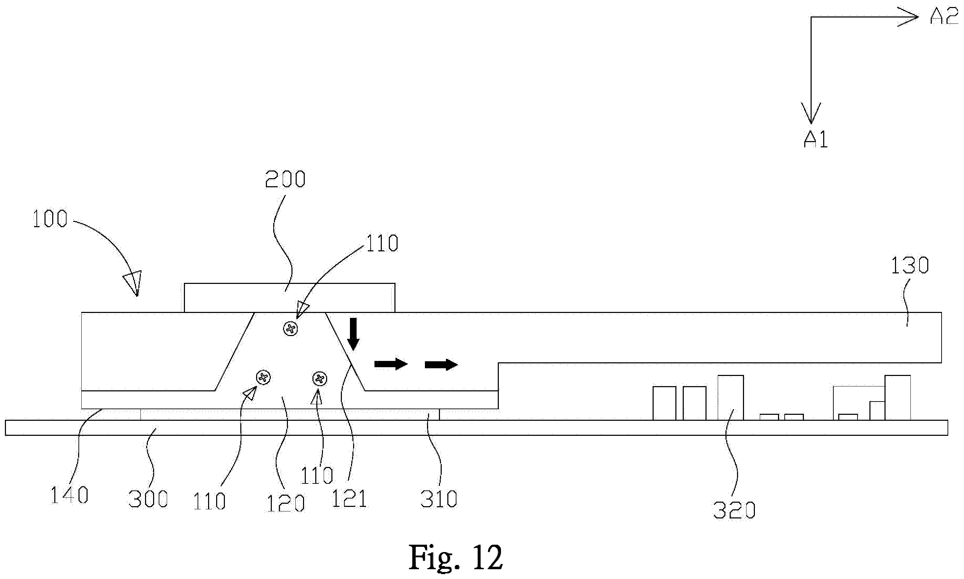

Alternatively, regarding the assembly of the heat sink 100, the air guide fins 120 and the heat dissipation fins 130 may be disposed interlacedly first, and then the connecting piece 110 provided with a screw 111 is used to pass through the plurality of air guide fins 120, making the plurality of air guide fins 120 and the plurality of heat dissipation fins 130 serially connected on the connecting piece 110 at intervals. After that, a nut 112 is used to at the other end of the connecting piece 110 to fasten the air guide fins 120 and the heat dissipation fins 130, so that the air guide fins 120 and the heat dissipation fins 130 are fixed on the connecting piece 110, and the longer sides of the air guide fins 120 and one side of the heat dissipation fins 130 form a contact face 140 together (as shown in Fig. 12). Since the heat dissipation fin 130 has a longer length than the air guide fin 120, when the plurality of heat dissipation fins 130 are "sandwiched" between the plurality of air guide fins 120 interlacedly, the gap formed between two adjacent heat dissipation fins 130 may be considered as an airflow channel 131.

Referring to Figs. 11 and 12, when the heat sink 100 of the fifth embodiment of the present invention is located between the fan 200 and the circuit board 300, the heat sink 100 is attached to the main electronic component 310 (e.g. a central processing unit or a graphic processing unit) on the circuit board 300 through the contact face 140 formed by the plurality of air guide fins 120 and the plurality of heat dissipation fins 130. In this way, the heat produced by the main electronic component 310 on the circuit board 300 is transmitted to all air guide fins 120 and heat dissipation fins 130 through the contact face 140. As described above, the airflow generated by the fan 200 flows towards the heat sink 100 along a first axial direction A1 parallel to the axle of the fan 200, confronts and bumps into the guiding faces 121 of the air guide fins 120, and then guided by the guiding faces 121 to direct from the first axial direction A1 to a second axial direction A2 perpendicular or inclined to the first axial direction A1 and to flow in the airflow channels 131 along the second axial direction A2. Consequently, the heat from the main electronic component 310 on the circuit board 300 is transmitted effectively to the outside, so the temperature of the main electronic component 310 on the circuit board 300 is decreased and the heat from other electronic components 320 on the circuit board 300 is dispersed at the same time.

During the aforementioned process, since the airflow generated by the fan 200 is compelled to change the flow direction from the first axial direction A1 to the second axial direction A2, followed by being guided by the airflow channels 131 of the heat dissipation fins 130, the flow rate of the airflow in the second axial direction A2 is increased on the whole. Therefore, when part of the airflow flows between the heat dissipation fins 130 and bumps into the surface of the air guide fins 120 and is reflected along the first axial direction A1, the reflected airflow moving towards the fan 200 along the first axial direction A1 will be driven by the above-mentioned airflow moving in the second axial direction A2 to flow along the second axial direction A2. Accordingly, the wind resistance of the airflow in the first axial direction can be effectively reduced, and occurrence of the turbulent flow on the surface of the air guide fins 120 or the surface of the circuit board 300 can be avoided. Therefore, the heat dissipation efficiency of the heat sink 100 is improved in terms of the main electronic component 310 and other electronic components 320 on the circuit board 300.

With the guiding faces of the air guide fins, the heat sink of the present invention diminishes effectively the wind resistance of the airflow resulted from the reflection from the heat sink or the circuit board. Also, the airflow guided by the guiding faces of the air guide fins can further disturb the air around the heat sink and the airflow flowing between the heat dissipation fins, thereby increasing the heat dissipation efficiency of the heat sink. Besides, through the contact between the air guide fins and the heat dissipation fins together with the utilization of different materials thereof, the thermal conductivity and heat dissipation efficiency of the heat sink can be further improved.

The aforementioned descriptions represent merely the preferred embodiment of the present invention, without any intention to limit the scope of the present invention thereto. Various equivalent changes, alterations, or modifications based on the claims of present invention are all consequently viewed as being embraced by the scope of the present invention.

## Claims

1. A heat sink (100) in cooperation with a fan (200) capable of generating an airflow along a first axial direction (A1), wherein the heat sink (100) comprises:
a connecting piece (110); and
a plurality of air guide fins (120) disposed on the connecting piece (110) at intervals, wherein each of the air guide fins (120) has a guiding face (121) that confronts the airflow in the first axial direction (A1) and directs the airflow to a second axial direction (A2), **characterized in that** the fan (200) is disposed on the connecting piece (110) and the connecting piece (110) is between the fan (200) and the plurality of air guide fins (120).

2. The heat sink (100) in cooperation with a fan (200) of claim 1, further comprising a plurality of heat dissipation fins (130) set at one side of the plurality of air guide fins (120) respectively and extending towards the second axial direction (A2), wherein each of the guiding faces (121) leads the airflow to circulate between adjacent two of the heat dissipation fins (130) along the second axial direction (A2).

3. The heat sink (100) in cooperation with a fan (200) of claim 1, further comprising a plurality of heat dissipation fins (130) each sandwiched between adjacent two of the air guide fins (120) and extending towards the second axial direction (A2), wherein each of the guiding faces (121) leads the airflow to circulate between adjacent two of the heat dissipation fins (130) along the second axial direction (A2).

4. The heat sink (100) in cooperation with a fan (200) of claim 1, wherein the plurality of the air guide fins (120) is serially connected on the connecting piece (110).

5. The heat sink (100) in cooperation with a fan (200) of claim 1, wherein the connecting piece (110) and the plurality of air guide fins (120) are formed integrally.

6. The heat sink (100) in cooperation with a fan (200) of claim 1, wherein the connecting piece (110) and the plurality of air guide fins (120) are made of metal or plastic.

7. The heat sink (100) in cooperation with a fan (200) of claim 1, wherein the guiding face (121) is a curved surface or an inclined plane.

## Patentansprüche

1. Wärmesenke (100) in Zusammenwirkung mit einem Lüfter (200), welcher in der Lage ist, einen Luftstrom entlang einer ersten axialen Richtung (A1) zu erzeugen, wobei die Wärmesenke (100) umfasst:
ein Verbindungsstück (110); und
eine Mehrzahl von Luft-Führungsrippen (120), welche an dem Verbindungsstück (110) in Intervallen angeordnet sind, wobei jede der Luft-Führungsrippen (120) eine Führungsfläche (121) aufweist, welche dem Luftstrom in der ersten axialen Richtung (A1) entgegentritt und den Luftstrom in eine zweite axiale Richtung (A2) richtet, **dadurch gekennzeichnet, dass** der Lüfter (200) an dem Verbindungsstück (110) angeordnet ist und das Verbindungsstück (110) zwischen dem Lüfter (200) und der Mehrzahl von Luft-Führungsrippen (120) ist.

2. Wärmesenke (100) in Zusammenwirkung mit einem Lüfter (200) nach Anspruch 1, ferner umfassend eine Mehrzahl von Wärme-Verteilungsrippen (130), welche an einer Seite der Mehrzahl von Luft-Führungsrippen (120) jeweils gesetzt sind und sich in Richtung der zweiten axialen Richtung (A2) erstrecken, wobei jede der Führungsflächen (121) den Luftstrom leitet, um zwischen zwei benachbarten der Wärme-Verteilungsrippen (130) entlang der zweiten axialen Richtung (A2) zu zirkulieren.

3. Wärmesenke (100) in Zusammenwirkung mit einem Lüfter (200) nach Anspruch 1, ferner umfassend eine Mehrzahl von Wärme-Verteilungsrippen (130), welche jeweils zwischen zwei benachbarten der Luft-Führungsrippen (120) eingefasst sind und sich in Richtung der zweiten axialen Richtung (A2) erstrecken, wobei jede der Führungsflächen (121) den Luftstrom leitet, um zwischen zwei benachbarten der Wärme-Verteilungsrippen (130) entlang der zweiten axialen Richtung (A2) zu zirkulieren.

4. Wärmesenke (100) in Zusammenwirkung mit einem Lüfter (200) nach Anspruch 1, wobei die Mehrzahl von Luft-Führungsrippen (120) seriell an dem Verbindungsstück (110) verbunden sind.

5. Wärmesenke (100) in Zusammenwirkung mit einem Lüfter (200) nach Anspruch 1, wobei das Verbindungsstück (110) und die Mehrzahl von Luft-Führungsrippen (120) integral gebildet sind.

6. Wärmesenke (100) in Zusammenwirkung mit einem Lüfter (200) nach Anspruch 1, wobei das Verbindungsstück (110) und die Mehrzahl von Luft-Führungsrippen (120) aus Metall oder Kunststoff hergestellt sind.

7. Wärmesenke (100) in Zusammenwirkung mit einem Lüfter (200) nach Anspruch 1, wobei die Führungsfläche (121) eine gekrümmte Fläche oder eine geneigte Ebene ist.

## Revendications

1. Dissipateur de chaleur (100) en coopération avec un ventilateur (200) capable de générer un courant d'air le long d'une première direction axiale (A1), dans lequel le dissipateur de chaleur (100) comprend :
une pièce de connexion (110) ; et
une pluralité d'ailettes de guidage d'air (120) disposées sur la pièce de connexion (110) par intervalles, dans lequel chacune des ailettes de guidage d'air (120) a une face de guidage (121) qui contre le courant d'air dans la première direction axiale (A1), et qui dirige le courant d'air vers une seconde direction axiale (A2), **caractérisé en ce que** le ventilateur (200) est disposé sur la pièce de connexion (110) et la pièce de connexion (110) se trouve entre le ventilateur (200) et la pluralité d'ailettes de guidage d'air (120).

2. Dissipateur de chaleur (100) en coopération avec un ventilateur (200) selon la revendication 1, comprenant en outre une pluralité d'ailettes de dissipation de chaleur (130) établies respectivement d'un côté de la pluralité d'ailettes de guidage d'air (120), et s'étendant vers la seconde direction axiale (A2), dans lequel chacune des faces de guidage (121) conduit le courant d'air pour qu'il circule entre deux ailettes adjacentes des ailettes de dissipation de chaleur (130) le long de la seconde direction axiale (A2).

3. Dissipateur de chaleur (100) en coopération avec un ventilateur (200) selon la revendication 1, comprenant en outre une pluralité d'ailettes de dissipation de chaleur (130), placées chacune en tenaille entre deux ailettes adjacentes des ailettes de guidage d'air (120) et s'étendant vers la seconde direction axiale (A2), dans lequel chacune des faces de guidage (121) conduit le courant d'air pour qu'il circule entre deux ailettes adjacentes des ailettes de dissipation de chaleur (130) le long de la seconde direction axiale (A2).

4. Dissipateur de chaleur (100) en coopération avec un ventilateur (200) selon la revendication 1, dans lequel la pluralité des ailettes de guidage d'air (120) est connectée en série sur la pièce de connexion (110).

5. Dissipateur de chaleur (100) en coopération avec un ventilateur (200) selon la revendication 1, dans lequel la pièce de connexion (110) et la pluralité d'ailettes de guidage d'air (120) sont formées d'un seul tenant.

6. Dissipateur de chaleur (100) en coopération avec un ventilateur (200) selon la revendication 1, dans lequel la pièce de connexion (110) et la pluralité d'ailettes de guidage d'air (120) sont réalisées en métal ou en plastique.

7. Dissipateur de chaleur (100) en coopération avec un ventilateur (200) selon la revendication 1, dans lequel la face de guidage (121) est une surface courbe ou un plan incliné.
